# EUROPEAN PATENT SPECIFICATION

(11) **EP 0 708 587 B1**
(45) Date of publication and mention of the grant of the patent: **26.08.1998**
(21) Application number: 95116427.6
(22) Date of filing: 18.10.1995
(51) Int. Cl.: H05K 13/08

(54) **Method and apparatus for mounting a part at a specific position**
Verfahren und Vorrichtung zur Montage eines Teils auf einer spezifischen Position
Procédé et dispositif de montage d'un composant dans une position spécifique

(30) Priority: 19.10.1994 JP 253813/94
(43) Date of publication of application: 24.04.1996
(73) Proprietor: YAMAHA HATSUDOKI KABUSHIKI KAISHA, Iwata-shi Shizuoka-ken, 438 (JP)
(72) Inventor: Hanamura, Naoki, Iwata-shi, Shizuoka-ken (JP)
(74) Representative: Grünecker, Kinkeldey, Stockmair & Schwanhäusser Anwaltssozietät

(56) References cited:
- EP-A- 0 582 171
- DE-A- 3 532 500

## Description

The present invention relates to a method of mounting a part, in particular a chip part, at a specific position onto a substrate such as a printed circuit board, comprising the steps of picking up the part by an attracting nozzle unit, transferring the part and placing same in a detection area of an optical detecting means at a recognition height, said optical detecting means emits parallel light beams for detecting a projected width of the part, subjecting the part to a recognition process wherein projected width data are obtained under rotation of the part, and mounting the part at the desired position.

Furthermore, the present invention relates to an apparatus for mounting a part, particularly a chip part, at a specific position onto a substrate such as a printed circuit board, comprising a movable mounting head unit having at least one attracting nozzle unit for picking up at least one part from a part supply unit, an optical detecting means emitting parallel light beams in a detection area for detecting a projected width of the part placed at a recognition height, a control unit for controlling the movement of the nozzle unit in response to values stored in a memory means and in response to projected width data.

A type of surface mounter has been generally known in which an electric part such as an IC is picked up from a parts-supply section by a parts-pickup head unit having a pickup nozzle, transferred over a positioned printed circuit board, and mounted to a specified position on the printed circuit board. This type of mounter is required to determine if the part is picked up correctly and also required, if the part is not picked up at a correct position on the part, to correct the mounting position accordingly. An arrangement to meet such requirements has been known in which optical means is provided which comprises a parallel light beam emitting section and a light beam receiving section so that projected width of the part is obtained by placing the part picked up by the pickup nozzle between the light emitting section and the light receiving section and rotating the part, and that the picked up state, picked up position error, etc. are checked by recognizing the part according to the projected part width.

When the mounter provided with the optical detection means as described above is used, the part is recognized after the pickup nozzle is raised to a recognition height where the part after being picked up corresponds to the parallel light beam emitting position of the optical detection means. However, since the optimum recognition height varies with the thickness and shape of the part, it is necessary to check in advance the recognition height suitable for the part, and to store the data in the memory of the controller of the mounter.

In the conventional process described above, the nozzle recognition height is determined by repeating tests at several nozzle heights. However, such a method is inefficient and it is difficult to obtain an optimum, accurate recognition height for the part.

EP-A-0 582 171 discloses a method and apparatus for mounting chip components adapted to recognize and remove errors in disposing and aligning a plurality of attracting nozzles at the mounting head of the apparatus. Specifically, the nozzles are checked by means of detecting external shape elements thereof in view of a correct positioning and selection of a certain attracting nozzle with respect to a certain chip component to be mounted among said plurality of said nozzles.

Accordingly, it is an objective of the present invention to provide an improved method and an improved apparatus of the afore-indicated type which allow quick and accurate determination of a recognition height suited for each part, and at which the main recognition process for mounting the part is reliably carried out.

As regards the method, the afore-mentioned objective is performed, according to the present invention, in that the optimum recognition height of each part attracted by said nozzle unit is determined by detecting a recognition height range in which a projected width of the part is smaller than or equal to a reference value, and calculating a specified position within said recognition height range as the optimum recognition height of the part.

Accordingly, it is discriminated whether or not recognition of the part is feasible, i.e. the part is located at a particular height range within the detection area. Then, within said detected recognition height range, a particular optimum position is calculated. Thus, a main recognition process can be performed more accurately as the recognition height for each part is adjusted to be an optimum. Comparison with a reference value and calculation on the basis of a specified position allows it to adapt the recognition height to the specifications of each part.

According to a preferred embodiment of the present invention, said recognition height range is obtained by the steps of moving said nozzle unit together with said part to a predetermined starting position, determining whether or not the projected width of the part is more than or equal to said reference value, storing the result of the determination step, displacing the part width by specified small amounts in a direction substantially perpendicular to said parallel light beams and repeating the determination and the storing step at each displaced position until a predetermined ending position is reached.

Accordingly, all possible recognition heights are obtained and the recognition height range is determined in a very effective and quick manner.

According to a further preferred embodiment, said predetermined starting position being defined as a low position at which a lower end of the nozzle unit being located within parallel light beams, which is additionally lowered by a predetermined distance so that the starting position resides in a position below the parallel light beams, and in that said predetermined ending position being defined as said position, which is subtracted by a part thickness and said predetermined distance so that ending position resides in a position height of the part higher than the starting position and above the parallel light beams.

According to a further preferred embodiment of the present invention, feasibility of the recognition of each part with a detection area can be achieved by two alternate ways.

Firstly, the nozzle being held at a certain angle while said projected width of the part is measured. Thus, optimum recognition height of each part is determined rather quickly.

Secondly, the detection of said recognition height range may further include measuring the projected width of the part by determining a minimum value of the projected width while said nozzle is being rotated and by comparing said minimum value with said reference value which is to be set as actual part width, so that minimum values of the projected part width which are substantially equal to the actual part width reference value are within said recognition height range.

Accordingly, optimum recognition height range is determined with good accuracy.

According to a further preferred embodiment, said specified position is calculated as the highest center height of the recognition height range detected over the widest recognition height range, as several recognition height ranges are detected.

Thus, optimum recognition height can be calculated independently from complexity of the part shape.

As regards the apparatus, the afore-mentioned objective is performed according to the present invention in that a determination means is provided for determining whether the projected width of said part 15 more than or equal to a reference value, and in that an operation means is provided for determining a recognition height range in response to an output of the determination means and for calculating a specified position within the recognition height range as the optimum recognition height of the part.

The mounting device is therefore advantageous in that it allows considerably quick and accurate determination of optimum recognition height suited for each part, while the optimum recognition height is detected by utilizing many devices also necessary for the main recognition process, so that not very many additional devices are necessary to determine optimum recognition height. Furthermore, the control unit occupies relatively small processing capacity.

Further preferred embodiments of the present invention are laid down in further dependent claims.

Hereinafter, the present invention is illustrated and explained in greater detail by means of a preferred embodiment thereof in connection with accompanying drawings, wherein:
Figure 1 is a schematic overall plan view showing a apparatus with a nozzle elevator mechanism according to a preferred embodiment of the invention,
Figure 2 is a schematic front view of the apparatus according to the embodiment of figure 1, said apparatus comprising a head unit movable in three dimensions,
Figure 3 is a schematic front view of the head unit of the apparatus according to figure 1,
Figure 4 is a schematic plan view of the optical detection means of the apparatus according to the embodiment of figure 1,
Figure 5 is a block diagram showing the control system of the apparatus according to the embodiment of figure 1,
Figure 6 is a flow chart showing the recognition height adjustment method of the apparatus of the embodiment of figure 1,
Figure 7 is an explanatory illustration of the operation of the nozzle and the part for the method according to figure 6,
Figure 8 is a flow chart showing an example of a part mounting process including a main recognition process,
Figure 9a is a three dimensional view of a part with special shape, and
Figure 9b is an explanatory illustration showing the part recognition height at the part example of figure 9a.

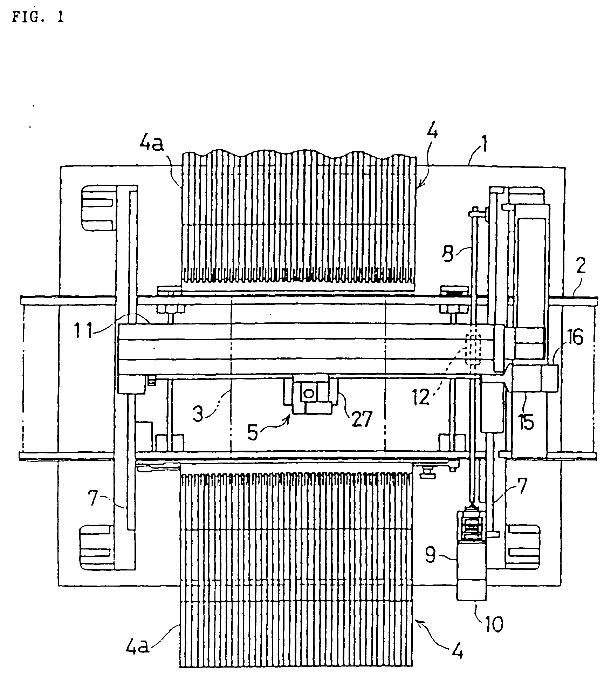

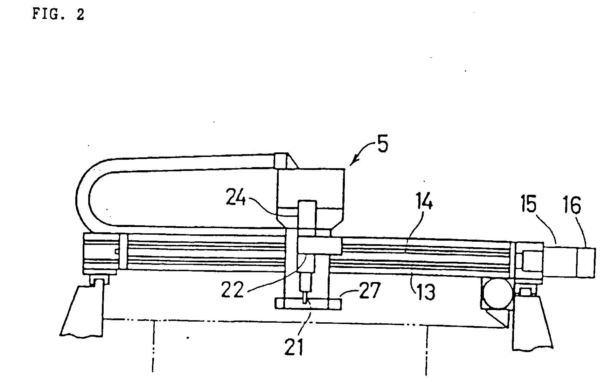

FIGs. 1 and 2 show an entire structure of an apparatus, i.e. a surface mounter. Referring to these drawings, a conveyor (2) for conveying a printed circuit board (3) is arranged on a base (1) of the surface mounter so that the printed circuit board (3) is conveyed on the conveyor (2) and stopped at a specified mounting work position. On both sides of the conveyor (2) are arranged parts supply sections (4). The parts supply section (4) is provided with parts feeders such as multiple row tape feeders (4a).

A head unit (5) for mounting parts is provided above the base (1). The head unit (5) is made to be capable of moving between the parts supply section (4) and the parts mounting section where the printed circuit board (3) is placed. In this embodiment, the movement is possible in directions of X axis (the direction of the conveyor 2) and Y axis (the direction normal to the X axis in a horizontal plane).

In other words, on the base (1) are arranged stationary rails (7) in the direction of Y axis, and a ball screw shaft (8) driven for rotation by a Y axis servomotor (9). A head unit support member (11) is arranged on the stationary rails (7). A nut (12) provided on the stationary rail (7) engages with the ball screw shaft (8). An X direction guide member (13) and a ball screw shaft (14) driven by an X axis servomotor (15) are arranged on the support member (11). A head unit (5) is movably supported by the guide member (13). A nut (not shown) provided on the head unit (5) engages with the ball screw shaft (14). The support member (11) is moved by the Y axis servomotor (9) in the Y axis direction. The head unit (5) is moved by the X axis servomotor (15) in the X axis direction relative to the support member (11). The Y axis servomotor (9) and the X axis servomotor (15) are respectively provided with position detection means (10) and (16) respectively comprising an encoder and others.

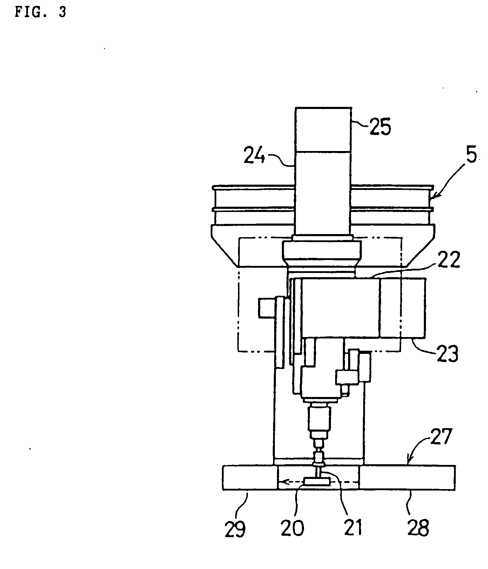

As shown in FIG. 3, the head unit (5) is provided with a pickup nozzle (21) for picking up an electronic part (20) and for movements in directions of both Z axis (vertical) and rotation about an R axis (nozzle center axis), and with a Z axis servomotor (22) (vertical drive means) and an R axis servomotor (24) for the nozzle member (21). The Z axis servomotor (22) and the R axis servomotor (24) are respectively provided with position detection means (23) and (25) respectively comprising an encoder and others.

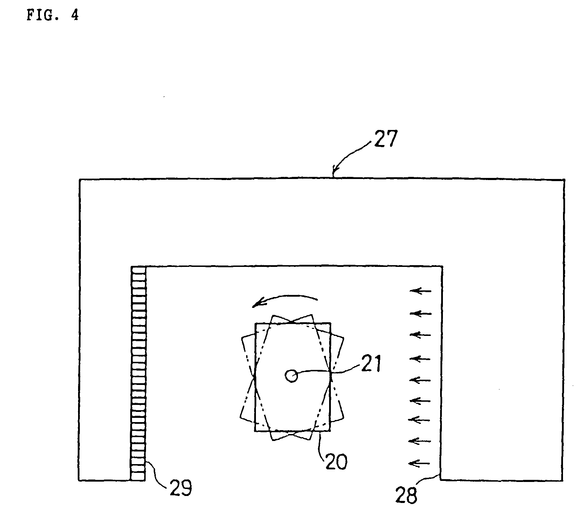

At the lower part of the head unit (5) is provided a laser unit (27) constituting optical detection means. As shown in FIGs. 3 and 4, the laser unit (27) comprises a laser beam generating section (parallel light beam emitting section) (28) and a light receiving section (29) located to face each other on both sides of a space where the pickup nozzle (21) is located. When the laser beam emitted from the laser beam generating section (28) is received by the light receiving section (29) and the part (20) picked up by the pickup nozzle (21) is at a specified recognition height, part of the laser beam is intercepted by the part (20), and the projection of the part (20) is detected.

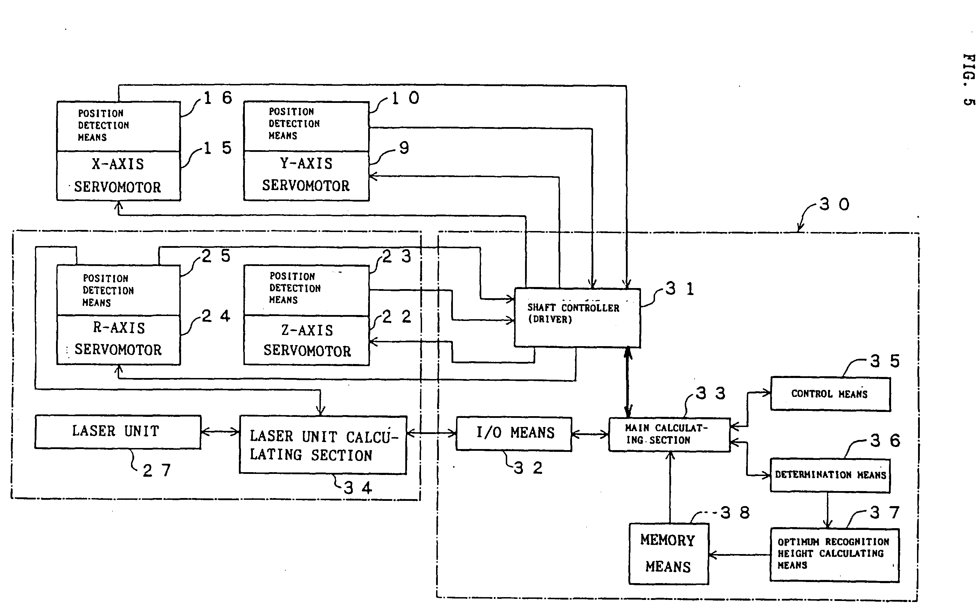

FIG. 5 shows an embodiment of a control system. In the figure, the mounter is provided with a main controller (30) comprising a shaft controller (driver) (31), input-output means (32), and a main operation section (33). The servomotors (9, 15, 22, and 24) respectively of the Y axis, X axis, Z axis, and R axis, and position detection means (10, 16, 23, and 25) provided respectively on those servomotors are connected to the shaft controller (31) which controls the drive of the servomotors (9, 15, 22, and 24). The laser unit (27) is electrically connected to a laser unit operation section (34) provided in the head unit (5). The laser unit operation section (34) is connected through the input-output means (32) to the main operation section (33).

The laser unit operation section (34) calculates the projected width of the part using signals from the laser unit (27) at the time of the part recognition. The shaft controller (31) and the main operation section (33) performs drive control and arithmetic operation for a series of mounting work including pickup, recognition, and mounting of the parts.

The main controller (30) is further provided with control means (35) for automatically adjusting the recognition nozzle height in preparation for the mounting work, determination means (36), optimum recognition height calculation means (37), and memory means (38). The control means (35) controls the Z axis servomotor to change the pickup nozzle height which has picked up the part at the time of adjustment in the preparatory state stepwise by small amounts. The determination means (36) determines feasibility of the part recognition from the detected results of the laser unit (27) at each of the nozzle heights changed by the specified small amounts. The operation means (37) determines a nozzle height zone where the part recognition is feasible from the determination data of the determination means (36), and calculates an optimum recognition height within the zone. The calculated optimum recognition height is stored in the memory means (38). The memory means (38) also has various other part data stored in advance in addition to the height data.

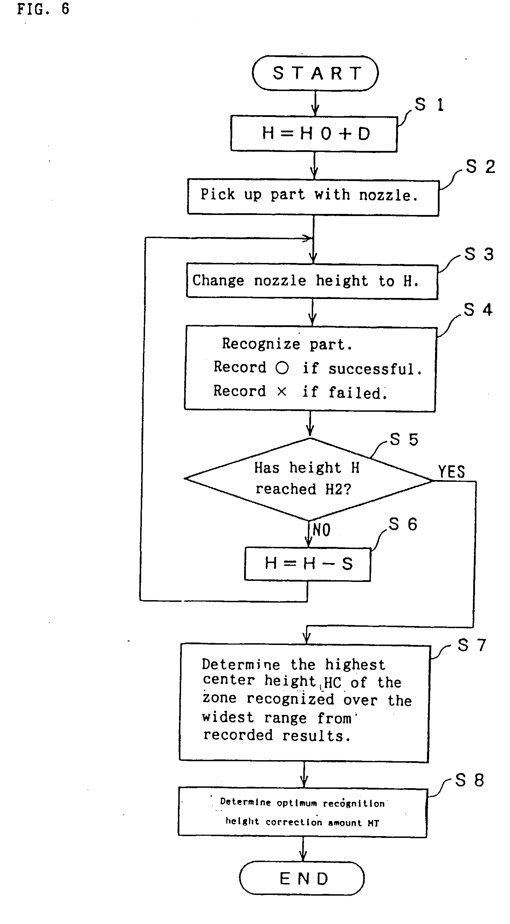

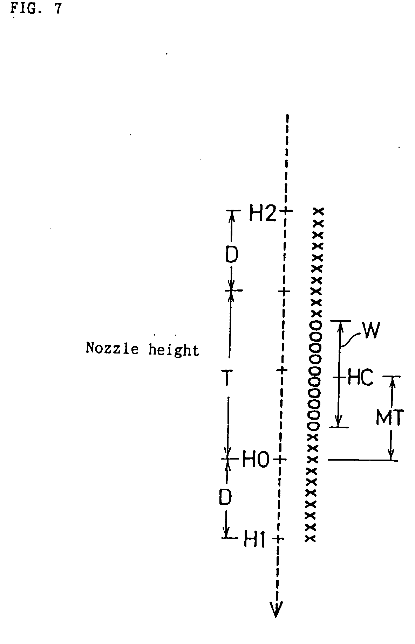

FIG. 6 is a flow chart showing the recognition nozzle height adjustment method for use with the mounter. FIG. 7 is a graphical expression of the method. Specific example of the recognition nozzle height adjustment method will be described in reference to these drawings. In FIG. 7, T is the part thickness, and H0 is the nozzle height where the lower end of the pickup nozzle (21) corresponds to the laser beam irradiation position. These data are stored in advance in the memory means (38). The nozzle height (H) used in the following description is assumed as positive in the downward direction from the origin at the topmost raised nozzle position.

When the process shown on the flow chart of FIG. 6 starts, first the initial position of the nozzle height is set to H = H0 + D . In other words, the lower end of the nozzle is set to a position (position H1 in FIG. 7) which is lower by a specified amount of D than the height H0 which corresponds to the laser irradiation position (step s1). The part (20) is picked up by the pickup nozzle (21) (step S2).

After the part is picked up, the pickup nozzle (21) is moved to the preset nozzle height H (step S3). At this nozzle height, the part is recognized according to the detection of projection by the laser unit (27), and feasibility of recognition is determined. In other words, if the recognition is successful because of the presence of the part at a position where the recognition is feasible, a circle (○) is recorded on a table and, if not, an X is recorded on the table (step S4). Specific method of the part recognition and determination based on the part recognition will be described later.

Next, it is determined if the nozzle height H has increased to a specified height H2 (step S5) and, if not, the nozzle height is changed as H = H - S (step S6) and the process returns to the step S3. The process of determining feasibility of recognition is repeated while the nozzle height H is changed by specified small amounts S. The small amount S is set to a value which is greater than a minimum movable distance of a nozzle height control mechanism but sufficiently smaller than the part thickness T. The specified height H2 is set to H2 = H0 - T - D , namely to a position higher by the part thickness T and the specified amount D than the height H0 where the lower end of the nozzle corresponds to the laser irradiation position of the laser unit (27).

As the steps S3 through S6 are repeated until the nozzle height reaches the specified value H2, determination data symbols of circles and X's representing the feasibility are recorded for each of the nozzle heights changed by small the amounts over the height zone (H1 - H2) as shown in FIG. 7.

When the nozzle reaches the specified recognition height H2, a center height HC of a zone W for which the circle symbols denoting the feasibility of recognition are recorded is calculated from the determination data (step S7). Since it is possible that recognition feasibility of the part (21) is erroneously determined in other zones than the zone W corresponding to the laser irradiation position, and that plural, discontinuous zones are determined to be feasible for the recognition. In that case, the widest of the zones is selected and its center height HC is calculated.

Next, the optimum recognition height adjustment amount MT is calculated as MT = H0 - HC (step S8) and stored in the memory means (38).

The recognition height adjustment process as shown in FIGs. 6 and 7 is carried out for various kinds of parts of different thicknesses and shapes, and the optimum recognition height adjustment amount MT is calculated for each of the parts and stored in the memory means (38).

According to the nozzle height adjustment method for recognition, feasibility of recognition is determined at each nozzle height while the nozzle height is changed stepwise by small constant amounts over a specified nozzle height zone under the state of the part (20) being picked up by the pickup nozzle (21). Using the determination data, a zone is determined where the recognition is feasible, and the center of the zone is determined as the optimum recognition height. Thus, the recognition height is automatically adjusted to determine the optimum recognition height quickly and accurately.

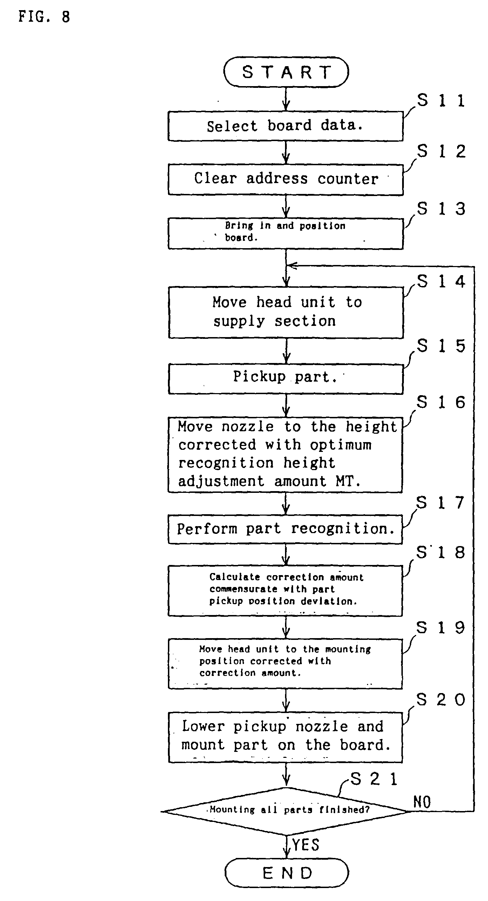

FIG. 8 is a flow chart showing an example of part mounting process performed after the recognition height adjustment described above. When the part mounting is started, first, data of the printed circuit board (3) is selected (step S11). At the same time, an address counter is cleared (step S12), and the printed circuit board (3) is inserted and set in position (step S13).

Next, the head unit (5) moves to the parts supply section (4) (step S14) and the part (20) is picked up (step S15) by the pickup nozzle (21). After the part (20) is picked up, the pickup nozzle (21) is raised by the drive of the Z axis servomotor (22) to the recognition height, the optimum recognition height adjustment amount MT determined in the recognition height adjustment process and stored in the memory means (38) is read out, and the pickup nozzle (21) is moved to the height added with the adjustment amount MT (step S16).

When the pickup nozzle (21) reaches the recognition height, part recognition is carried out (step S17). The part recognition is carried out in the following sequence; as shown in FIG. 4, the pickup nozzle (21) which has picked up the part (20) is rotated by a specified angle in a specified direction. While the pickup nozzle (21) is being rotated, projected width of the part is measured using signals from the laser unit (27) at every constant small angular rotation. When the projected width of the part becomes a minimum value (the state shown with solid lines in FIG. 4), the projected width of the part, nozzle rotation angle, and a center position of projection are determined. According to these data, a center position of the part is determined, and a correction amount commensurate with deviation is calculated (step S18). Since the methods of the part recognition and calculating the correction amount according to the recognition are conventionally known (for example Japanese Unexamined Patent Publication 6-21697), their detailed description is omitted here.

Next, the head unit (5) moves to the mounting position added with the correction amount (step S19). The pickup nozzle (21) is further lowered and the part (20) is mounted on the printed circuit board (3) (step S20). Then it is determined if all the parts are mounted on the printed circuit board (3) (step S21). The steps S14 through S20 are repeated until all the parts are mounted.

Since the recognition height adjustment amount MT is accurately calculated in advance to be added to the nozzle height to which the pickup nozzle (21) is raised when the part is recognized after being picked up during the mounting operation, the part recognition using the laser unit (27) and part mounting position correction according to the recognition are performed with good accuracy.

The recognition nozzle height adjustment process (FIGs. 6 and 7) has only to be carried out in the preparatory stage before the mounting work. If there are any parts for which the state of recognition is in error in the mounting process, it is possible to arrange to record the number of errors so that the recognition height can be readjusted by the recognition nozzle height adjustment process when the number of errors exceeds a predetermined value.

In the recognition nozzle height adjustment process (FIGs. 6 and 7), specific methods of determining the feasibility of the part recognition at each of the nozzle heights may be devised in various ways. A simple method for example may be to measure the projected width of the part using signals from the laser unit (27) under the state of the nozzle (21) held at a certain angle without rotating it, and to determine that the recognition is successful if the projected width is not less than a specified value and unsuccessful if less than the specified value.

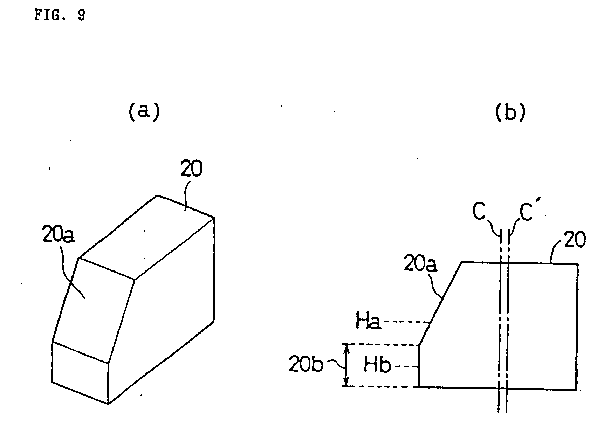

Another method of determination in the step S4 described above may be as follows: In a similar manner to that of the part recognition carried out in the mounting process (the step S17 of FIG. 8), the projected width is measured while the pickup nozzle (21) is rotated, the minimum value of the projected width is determined and compared with the part width, and from that data the feasibility of recognition is determined. In other words, since the minimum value of the projected width corresponds to the part width (the length of one side of the part) when the part (20) is in the laser beam irradiation position, recognition is determined as successful if the minimum value of the projected width is approximately equal to the part width and, if not, unsuccessful. When this method is used, the recognition height can be determined with a higher accuracy when the part (20) has a special shape, as shown in FIG. 9 for example, with an oblique portion (20a) on one side.

In other words, when the part (20) shown in FIG. 9 is handled, if the position Ha in the center of the part height is assumed as the recognition height corresponding to the laser beam irradiation position, the position Ha is on the oblique portion (20a). Therefore, the part center position C' obtained from the recognition processes S17 and S18 of FIG. 8 is displaced from the correct part center position C. To obtain the correct part center position C in such a case, in the step S4, the minimum value of the projected width is obtained while the pickup nozzle (21) is being rotated, and the minimum value is compared with the part width. According to the result, a height zone where the wide width portion (20b) of the lower portion of the part corresponds to the laser beam irradiation position is assumed as the recognition feasible zone, and its center position Hb is assumed as the recognition position. Thus, the correct part center position C is obtained.

The surface mounter provided with a parallel light beam emitting section and a light receiving section for recognizing the part picked up by the pickup nozzle as described above, since it is arranged that the height of the pickup nozzle which has picked up the part is changed stepwise by small amounts and feasibility of the part recognition is determined at each of the nozzle heights, the part recognition feasible zone is checked from the determination data, and the optimum recognition height is set. As a result, the recognition height adjustment is carried out automatically, and the optimum recognition height can be set quickly with a good accuracy.

## Claims

1. Method of mounting a part (20), in particular a chip part, at a specific position onto a substrate such as a printed circuit board (3), comprising the steps of picking up the part (20) by an attracting nozzle unit (21), transferring the part (20) and placing same in a detection area of an optical detecting means (28, 29) at a recognition height, said optical detecting means emits parallel light beams for detecting a projected width of the part (20), subjecting the part (20) to a recognition process wherein projected width data are obtained under rotation of the part (20), and mounting the part (20) at the desired position, **characterized in that** optimum recognition height (HC) of each part (20) attracted by said nozzle unit (21) is determined by detecting a recognition height range (W) in which a projected width of the part (20) is more than or equal to a reference value and calculating a specified position within said recognition height range as the optimum recognition height (HC) of the part (20).

2. Method according to claim 1, **characterized in that** said recognition height range (W) is obtained by the steps of moving said nozzle unit (21) together with said part (20) to a predetermined starting position (H1), determining whether or not the projected width of the part (20) is more than or equal to said reference value, storing the result of the determination step, displacing the part stepwise by specified small amounts (S) in a direction substantially perpendicular to said parallel light beams and repeating the determination and the storing step at each displaced position until a predetermined ending position (H2) is reached.

3. Method according to claim 2, **characterized in that** said predetermined starting position (H1) being defined as a low position (H0), at which a lower end of the nozzle unit (21) being located within the parallel light beams, which is additionally lowered by a predetermined distance (D) so that starting position (H1) resides in a position below the parallel light beams, and in that said predetermined ending position (H2) being defined as said position (H0), which is subtracted by a part thickness (T) and said predetermined distance (D), so that ending position (H2) resides in a position height of the part (20) higher than the starting position (H1) and above the parallel light beams.

4. Method according to at least one of the preceding claims, **characterized in that** said nozzle (21) being held at a certain angle while said projected width of the part (20) is measured.

5. Method according to at least one of claims 1 to 3, **characterized in that** said recognition height range (W) is detected by measuring the projected width of the part (20) by determining a minimum value of the projected width while said nozzle (21) is being rotated, and by comparing said minimum value with said reference value which is to be set as the actual part width, so that minimum values of the projected part width which are substantially equal to the actual part width reference value, are within said recognition height range (W).

6. Method according to one of the preceding claims, **characterized in that** said specified position is calculated as a center height (HC) within said recognition height range (W), if a single recognition height range (W) is detected.

7. Method according to at least one of claims 1 to 5, **characterized in that** said specified position is calculated as the highest center height (HC) of the recognition height range (W) detected over the widest recognition height range, if several recognition height ranges (W) are detected.

8. Method according to at least one of the preceding claims, **characterized in that** an optimum recognition height adjustment amount (MT) is calculated as the difference between low position (H0) and center height position (HC) and in that said adjustment amount (MT) is stored.

9. Method according to at least one of the preceding claims, **characterized in that** said optimum recognition height adjustment amount is determined for each part (20) in advance to performing a mounting part recognition at said optimum recognition height (HC).

10. Apparatus for mounting a part (20), particularly a chip part, at a specific position onto a substrate such as a printed circuit board (3), comprising a movable mounting head unit (5) having at least one attracting nozzle unit (21) for picking up at least one part (20) from a part supply unit (4), an optical detecting means (28, 29) emitting parallel light beams in a detection area for detecting a projected width of the part (20) placed at a recognition height, a control unit (30) for controlling the movement of the nozzle unit (21) in response to values stored in a memory means (38) and in response to projected width data, in particular for performing the method of claim 1, **characterized in that** a determination means (36) is provided for determining whether the projected width of said part (20) is more than or equal to a reference value, and in that an operation means (37) is provided for determining a recognition height range (W) in response to an output of the determination means (36) and for calculating a specified position (HC) within the recognition height range (W) as the optimum recognition height of the part (20).

11. Apparatus according to claim 10, **characterized in that** the optical detecting means is formed by a laser unit (27) comprising a laser beam generating section (28) for emitting parallel laser beams in a horizontal plane (X-Y) and a light receiving section (29) disposed opposite to said emitting section (28) at a lower end of said mounting head unit (5).

12. Apparatus according to claims 10 or 11, **characterized in that** the mounting head unit (5) includes a Z-axis servomotor (22) for moving the nozzle unit (21) in a vertical direction perpendicular to said detection area of said optical detecting means and a R-axis servomotor (24) for rotating the nozzle unit (21) around a vertical axis.

13. Apparatus according to claim 12, **characterized in that** said control unit (30) comprising a control means (35) for adjusting the recognition nozzle height (HC), said determination means (36), said operation means (37), said memory means (38), a main calculating section (33) for performing arithmetic operations, a shaft controller (31) for controlling a drive shaft of at least said Z-axis servomotor (22) and said R-axis servomotor (24), and in that said control unit (30) being connected to the laser unit (27) via a laser unit calculating section (34) and an input/output means (32), wherein said main calculating section (33) being electrically connected with said shaft controller (31), said input/output means (32), said control means (35), said determination means (36) and said memory means (38), wherein said determination means (36) is electrically connected with said memory means (38) via said operation means (37).

14. Apparatus according to claim 13, **characterized in that** said control means (35) controls the Z-axis servomotor (22) to move the part (20) attracted by the nozzle unit (21) from a predetermined starting position (H1) at which said part (20) is below said detection area of said optical detecting means (28, 29) upwards, stepwise by specified small amounts (S) until a predetermined ending position (H2) at which the part (20) is located above said detection area of said optical detecting means (28, 29) is reached.

15. Apparatus according to at least one of claims 12 to 14, **characterized in that** said R-axis servomotor (24) is provided for rotating the part (20) at each vertical position changed by said specified small amounts (S).

## Patentansprüche

1. Verfahren zum Montieren eines Bauteils (20), insbesondere eines Chipbauteils, an einer spezifischen Position auf einem Substrat, wie z.B. eine gedruckte Leiterplatte (3), mit den Verfahrensschritten, Aufnehmen des Bauteils (20) mittels einer Anziehungsdüseneinheit (21), Übertragen des Bauteils (20) sowie Plazieren desselben in einem Erfassungsbereich einer optischen Erfassungseinrichtung (28, 29) bei einer Erkennungshöhe, wobei diese optische Erfassungseinrichtung parallele Lichtstrahlen abgibt zur Erfassung einer Projektionsweite des Bauteils (20), Unterziehen des Bauteils (20) eines Erkennungsprozesses, in welchem die Daten der Projektionsweite erhalten werden während der Rotation des Bauteils (20), und Montieren des Bauteils (20) an der gewünschten Position, **dadurch gekennzeichnet**, daß die optimale Erkennungshöhe (HC) von jedem Bauteil (20), das von der Düseneinheit (21) angeogen worden ist, festgelegt wird durch Erfassen eines Erkennungshöhenbereichs (W), in welchem eine Projektionsweite des Bauteils (20) größer oder gleich einem Referenzwert ist, und durch Berechnen einer spezifizierten Position innerhalb dieses Erkennungshöhenbereichs als die optimale Erkennungshöhe (HC) des Bauteils (20).

2. Verfahren nach Anspruch 1, **dadurch gekennzeichnet**, daß dieser Erkennungshöhenbereich (W) erhalten wird durch die Schritte, Bewegen dieser Düseneinheit (21) zusammen mit diesem Bauteil (20) zu einer vorbestimmten Startposition (H1), Festlegen, ob die Projektionsweite des Bauteils (20) größer oder gleich diesem Referenzwert ist oder nicht, Abspeichern des Ergebnisses von diesem Festlegungsschritt, stufenweises Versetzen des Bauteils um spezifizierte kleine Größen (S) in einer Richtung, die im wesentlichen senkrecht zu diesen parallelen Lichtstrahlen verläuft, und Wiederholen des Festlegungsschrittes und des Abspeicherungsschrittes bei jeder Versatzposition, bis eine vorbestimmte Endposition (H2) erreicht ist.

3. Verfahren nach Anspruch 2, **dadurch gekennzeichnet**, daß diese vorbestimmte Startposition (H1) definiert wird als eine niedrige Position (H0), bei welcher ein unteres Ende der Düseneinheit (21) innerhalb der parallelen Lichtstrahlen angeordnet ist, welche zusätzlich um eine vorbestimmte Distanz (D) abgesenkt wird derart, daß die Startposition (H1) in einer Position unterhalb der parallelen Lichtstrahlen sich befindet, und daß diese vorbestimmte Endposition (H2) definiert wird als diese Position (H0), die substrahiert wird mit der Bauteilstärke (T) und dieser vorbestimmten Distanz (D), so daß sich die Endposition (H2) in einer Positionshöhe des Bauteils (20'), die höher ist als die Startpositon (H1) und unterhalb der parallelen Lichtstrahlen liegt, befindet.

4. Verfahren nach mindestens einem der vorstehenden Ansprüche, **dadurch gekennzeichnet**, daß diese Düse (21) mit einem bestimmten Winkel gehalten wird, während diese Projektionsweite des Bauteils (20) gemessen wird.

5. Verfahren nach mindestens einem der Ansprüche 1 bis 3, **dadurch gekennzeichnet**, daß der Erkennungshöhenbereich (W) erfaßt wird durch Messen der Projektionsweite des Bauteils (20) mittels Festlegen eines minimalen Wertes für die Projektionsweite, während diese Düse (21) rotiert wird, und durch Vergleichen dieses minimalen Wertes mit diesem Referenzwert, der als die aktuelle Bauteilweite festzusetzen ist, so daß die minimalen Werte der Projektionsweiten des Bauteils, die im wesentlichen gleich dem aktuellen Bauteilweitenreferenzwert sind, sich innerhalb des Erkennungshöhenbereichs (W) befinden.

6. Verfahren nach einem der vorstehenden Ansprüche, **dadurch gekennzeichnet**, daß die spezifizierte Position als eine Zentrumshöhe (HC) innerhalb dieses Erkennungshöhenbereiches (W) berechnet wird, falls ein einzelner Erkennungshöhenbereich (W) erfaßt worden ist.

7. Verfahren nach mindestens einem der Ansprüche 1 bis 5, **dadurch gekennzeichnet**, daß die spezifizierte Position als die höchste Zentrumshöhe (HC) des Erkennungshöhenbereiches (W) berechnet wird, die über den breitesten Erkennungshöhenbereich erfaßt worden ist, falls mehrere Erkennungshöhenbereiche (W) erfaßt worden sind.

8. Verfahren nach mindestens einem der vorstehenden Ansprüche, **dadurch gekennzeichnet**, daß ein optimaler Erkennungshöheneinstellwert (MT) als die Differenz zwischen der tiefen Position (H0) und der Zentrumshöhenposition (HC) berechnet wird, und daß dieser Einstellwert (MT) abgespeichert wird.

9. Verfahren nach mindestens einem der vorstehenden Ansprüche, **dadurch gekennzeichnet**, daß dieser optimale Erkennungshöheneinstellwert für jedes Bauteil (20) vor der Durchführung einer Bauteilerkennung bei dieser optimalen Erkennungshöhe (HC) festgelegt wird.

10. Vorrichtung zum Montieren eines Bauteils (20), insbesondere eines Chipbauteils, an einer spezifischen Position auf einem Substrat, wie z.B. einer gedruckten Leiterplatte (3), umfassend eine bewegbare Montierkopfeinheit (5) mit mindestens einer Anziehungsdüseneinheit (21) zum Aufnehmen von zumindest einem Bauteil (20) von einer Bauteilzuführeinheit (4), eine optische Erfassungseinrichtung (28, 29), die parallele Lichtstrahlen in einen Erfassungsbereich zur Erfassung einer Projektionsweite des Bauteils (20), das in einer Erkennungshöhe plaziert ist, abstrahlt, eine Steuereinheit (30) zur Steuerung der Bewegung der Düseneinheit (21) in Abhängigkeit von in einer Speichereinrichtung (38) abgelegten Werten und in Abhängigkeit von Projektionsweiten-Daten, insbesondere zur Durchführung des Verfahrens gemäß Anspruch 1, **dadurch gekennzeichnet**, daß eine Festlegungseinrichtung (36) vorgesehen ist zum Festlegen, ob die Projektionsweite des Bauteils größer oder gleich einem Referenzwert ist, und daß eine Betätigungseinrichtung (37) vorhanden ist zur Festlegung eines Erkennungshöhenbereichs (W) in Abhängigkeit von einem Ausgang der Feststellungseinrichtung (36) und zum Berechnen einer spezifizierten Position (HC) innerhalb dieses Erkennungshöhenbereichs (W) als die optimale Erkennungshöhe für das Bauteil (20).

11. Vorrichtung nach Anspruch 10, **dadurch gekennzeichnet**, daß die optische Erfassungseinrichtung von einer Lasereinheit (27) gebildet wird mit einem Laserstrahlerzeugungsabschnitt (28) zur Abgabe paralleler Laserstrahlen in einer horizontalen Ebene (X-Y) und mit einem lichtempfangenden Abschnitt (29), der diesem abgebenden Abschnitt (28) an einem unteren Ende dieser Montierkopfeinheit (5) gegenüberliegend angeordnet ist.

12. Vorrichtung nach Anspruch 10 oder 11, **dadurch gekennzeichnet**, daß die Montierkopfeinheit (5) einen Z-Achsen-Servomotor (22) zur Bewegung der Düseneinheit (21) in einer vertikalen Richtung senkrecht zu diesem Erfassungsbereich von dieser optischen Erfassungseinrichtung aufweist sowie einen R-Achsen-Servomotor (24) enthält zum Rotieren der Düseneinheit (21) um eine vertikale Achse.

13. Vorrichtung nach Anspruch 12, **dadurch gekennzeichnet**, daß diese Steuereinheit (30) umfaßt eine Steuereinrichtung (35) zur Einstellung der Erkennungsdüsenhöhe (HC), diese Festlegungseinrichtung (36), diese Betätigungseinrichtung (37), diese Speichereinrichtung (38), einen Hauptberechnungsabschnitt (33) zur Durchführung arithmetischer Operationen, einen Wellenkontroller (31) zur Steuerung einer Antriebswelle von zumindst diesem Z-Achsen-Servomotor (22) und diesem R-Achsen-Servomotor (24), und daß diese Steuereinheit (30) an der Lasereinheit (27) über eine Lasereinheit-Berechnungssektion (34) sowie einer Eingabe/Ausgabe-Einrichtung (32) angeschlossen ist, worin dieser Hauptberechnungsabschnitt (33) elektrisch mit diesem Wellenkontroller (31), diesen Eingabe/Ausgabe-Einrichtungen (32), dieser Steuereinrichtung (35), dieser Festlegungseinrichtung (36) und dieser Speichereinrichtung (38) verbunden ist, worin diese Festlegungseinrichtung (36) elektrisch mit dieser Speichereinrichtung (38) über diese Betätigungseinrichtung (37) verbunden ist.

14. Vorrichtung nach Anspruch 13, **dadurch gekennzeichnet**, daß diese Steuereinrichtung (35) den Z-Achsen-Servomotor (22) steuert, um das Bauteil (20), das von der Düseneinheit (21) angezogen worden ist, von einer vorbestimmten Startposition (H1), bei welcher dieses Bauteil (20) sich unterhalb dieses Erfassungsbereichs der optischen Erfassungseinrichtung (28, 29) befindet, stufenweise nach oben um spezifizierte kleine Größen (S) zu bewegen, bis eine vorbestimmte Endposition (H2) erreicht ist, in welcher das Bauteil sich oberhalb des Erfassungsbereichs dieser optischen Erfassungseinrichtung (28, 29) befindet.

15. Vorrichtung nach zumindest einem der Ansprüche 12 bis 14, **dadurch gekennzeichnet**, daß dieser R-Achsen-Servomotor (24) dazu angeordnet ist, um dieses Bauteil (20) bei jeder vertikalen Position, die durch diese spezifizierten kleinen Werte (S) geändert wird, zu rotieren.

## Revendications

1. Procédé de montage d'un composant (20), en particulier un composant de circuit intégré, dans une position spécifique sur un substrat tel qu'une carte de circuit imprimé (3), comprenant les étapes consistant à prélever le composant (20) par une unité de buse d'attraction (21), à transférer le composant (20) et à le placer dans une zone de détection d'un moyen de détection optique (28, 29) à une hauteur de reconnaissance, ledit moyen de détection optique émettant des faisceaux de lumière parallèle pour détecter une largeur projetée du composant (20), à soumettre le composant (20) à un processus de reconnaissance, les données de largeur projetée étant obtenues en faisant tourner le composant (20) et en montant le composant (20) dans la position souhaitée, caractérisé en ce que la hauteur de reconnaissance optimale (HC) de chaque composant (20) prélevé par ladite unité de buse (21) est déterminée en détectant une fourchette de hauteur de reconnaissance (W) dans laquelle une largeur projetée du composant (20) est supérieure ou égale à une valeur de référence et en calculant une position spécifiée dans ladite fourchette de hauteur de reconnaissance comme hauteur de reconnaissance optimale (HC) du composant (20).

2. Procédé selon la revendication 1, caractérisé en ce que ladite fourchette de hauteur de reconnaissance (W) est obtenue par les étapes consistant à amener ladite unité de buse (21) en même temps que ledit composant (20) à une position de départ prédéterminée (H1), à déterminer si oui ou non la largeur projetée du composant (20) est supérieure ou égale à ladite valeur de référence, à mettre en mémoire le résultat de l'étape de détermination, à déplacer le composant pas à pas de petites quantités spécifiées (S) dans une direction sensiblement perpendiculaire auxdits faisceaux de lumière parallèle et à répéter l'étape de détermination et de mise en mémoire dans chaque position déplacée jusqu'à ce qu'une position finale prédéterminée (H2) soit atteinte.

3. Procédé selon la revendication 2, caractérisé en ce que ladite position de départ prédéterminée (H1) est définie comme une position basse (H0), dans laquelle une extrémité inférieure de l'unité de buse (21) est située dans les faisceaux de lumière parallèle, qui est de plus abaissée d'une distance prédéterminée (D), de telle sorte que la position de départ (H1) se trouve être une position située au-dessous des faisceaux de lumière parallèle, et en ce que ladite position finale prédéterminée (H2) est définie comme ladite position (H0), dont on soustrait une épaisseur de composant (T) et ladite distance prédéterminée (D), de sorte que la position finale (H2) se trouve être une hauteur de position du composant (20) plus élevée que la position de départ (H1) et au-dessus des faisceaux de lumière parallèle.

4. Procédé selon l'une au moins des revendications précédentes, caractérisé en ce que ladite unité de buse (21) est maintenue à un certain angle pendant que ladite largeur projetée du composant (20) est mesurée.

5. Procédé selon l'une au moins des revendications 1 à 3, caractérisé en ce que ladite fourchette de hauteur de reconnaissance (W) est détectée en mesurant la largeur projetée du composant (20) en déterminant une valeur minimale de la largeur projetée pendant qu'on fait tourner ladite buse (21), et en comparant ladite valeur minimale à ladite valeur de référence qui doit être fixée comme largeur réelle du composant, de sorte que les valeurs minimales de la largeur projetée du composant qui sont sensiblement égales à la valeur de référence de largeur réelle du composant, sont dans ladite fourchette de hauteur de reconnaissance (W).

6. Procédé selon l'une des revendications précédentes, caractérisé en ce que ladite position spécifiée est calculée comme une hauteur centrale (HC) dans ladite fourchette de hauteur de reconnaissance (W), si une seule fourchette de hauteur de reconnaissance (W) est détectée.

7. Procédé selon l'une au moins des revendications 1 à 5, caractérisé en ce que ladite position spécifiée est calculée comme la hauteur centrale la plus élevée (HC) de la fourchette de hauteur de reconnaissance (W) détectée dans la plus large fourchette de hauteur de reconnaissance, si plusieurs fourchettes de hauteur de reconnaissance (W) sont détectées.

8. Procédé selon l'une au moins des revendications précédentes, caractérisé en ce qu'une valeur de réglage de hauteur de reconnaissance optimale (MT) est calculée comme la différence entre la position basse (H0) et la position de hauteur centrale (HC) et en ce que ladite valeur de réglage (MT) est mise en mémoire.

9. Procédé selon l'une au moins des revendications précédentes, caractérisé en ce que ladite valeur de réglage (MT) de la hauteur de reconnaissance optimale est déterminée pour chaque composant (20) avant d'effectuer une reconnaissance de composant de montage à ladite hauteur de reconnaissance optimale (HC).

10. Dispositif de montage d'un composant (20), en particulier un composant de circuit intégré, dans une position spécifique sur un substrat tel qu'une carte de circuit imprimé (3), comprenant une unité de tête de montage mobile (5) comportant au moins une unité de buse d'attraction (21) pour prélever au moins un composant (20) dans une unité (4) de fourniture de composants, un moyen de détection optique (28, 29) émettant des faisceaux de lumière parallèle dans une zone de détection pour détecter une largeur projetée du composant (20) placé à une hauteur de reconnaissance, une unité de commande (30) pour commander le mouvement de l'unité de buse (21) en réponse à des valeurs stockées dans un moyen formant mémoire (38) et en réponse à des données de largeur projetée, en particulier pour exécuter le procédé selon la revendication 1, caractérisé en ce qu'un moyen de détermination (36) est prévu pour déterminer si la largeur projetée dudit composant (20) est supérieure ou égale à une valeur de référence, et en ce qu'un moyen d'exploitation (37) est prévu pour déterminer une fourchette de hauteur de reconnaissance (W) en réponse à une sortie du moyen de détermination (36) et pour calculer une position spécifiée (HC) située dans la fourchette de hauteur de reconnaissance (W) comme valeur de reconnaissance optimale du composant (20).

11. Dispositif selon la revendication 10, caractérisé en ce que le moyen de détection optique est formé par une unité laser (27) comportant une partie (28) générant un faisceau laser destinée à émettre des faisceaux laser parallèles dans un plan horizontal (X-Y) et une partie (29) réceptrice de lumière disposée en face de ladite partie émettrice (28) à une extrémité inférieure de ladite unité (5) de tête de montage.

12. Dispositif selon les revendications 10 ou 11, caractérisé en ce que l'unité (5) de tête de montage comporte un servomoteur (22) d'axe Z pour déplacer l'unité de buse (21) dans une direction verticale perpendiculaire à ladite zone de détection dudit moyen de détection optique et une servomoteur (24) d'axe R pour faire tourner l'unité de buse (21) autour d'un axe vertical.

13. Dispositif selon la revendication 12, caractérisé en ce que l'unité de commande (3) comporte un moyen de commande (35) pour régler la hauteur (HC) de la buse de reconnaissance, ledit moyen de détermination (36), ledit moyen d'exploitation (37), ledit moyen de mémoire (38), une partie de calcul principale (33) pour effectuer des opérations arithmétiques, un contrôleur d'arbre (31) pour commander un arbre d'entraînement d'au moins ledit servomoteur (22) d'axe Z et ledit servomoteur (24) d'axe R, et en ce que ladite unité de commande (30) est connectée à l'unité laser (27) via une partie (34) de calcul de l'unité laser et un moyen d'entrée/sortie (32), ladite partie de calcul principale (33) étant connectée électriquement audit contrôleur d'arbre (31), audit moyen d'entrée/sortie (32), audit moyen de commande (35), audit moyen de détermination (36) et audit moyen de mémoire (38), ledit moyen de détermination (36) étant connecté audit moyen de mémoire (38) via ledit moyen d'exploitation (37).

14. Dispositif selon la revendication 13, caractérisé en ce que le moyen de commande (35) commande le servomoteur (22) d'axe Z pour déplacer vers le haut le composant (20) attiré par l'unité de buse (22) d'une position de départ prédéterminée (H1), dans laquelle ledit composant (20) est situé au-dessous de la zone de détection dudit moyen de détection optique (28, 29), pas à pas de petites quantités spécifiées (S) jusqu'à ce que soit atteinte une position finale prédéterminée (H2), dans laquelle le composant (20) est situé au-dessus de ladite zone de détection dudit moyen de détection optique (28, 29).

15. Dispositif selon l'une au moins des revendications 12 à 14, caractérisé en ce que ledit servomoteur (24) d'axe R est prévu pour faire tourner, à chaque position verticale modifiée, le composant (20) desdites petites quantités spécifiées (S).
